# EUROPEAN PATENT APPLICATION

(11) **EP 2 448 378 A1**
(43) Date of publication of application: **02.05.2012**
(21) Application number: 10188939.2
(22) Date of filing: 26.10.2010
(51) Int. Cl.: H05K 1/18, H05K 3/46, H01L 23/498, H01L 23/538

(54) **Composite build-up materials for embedding of active components**

(71) Applicant: ATOTECH Deutschland GmbH, 10553 Berlin (DE)
(72) Inventor: Galster, Norbert, 4052, Basel (CH); Kress, Jürgen, 4125, Riehen (CH); Laver, Hugh, 4153, Reinach (CH)
(74) Representative: Wonnemann, Jörg

(57) **Abstract**

Disclosed are composite build-up materials for the manufacture of printed circuit boards, IC substrates, chip packages and the like. The composite build-up materials are suitable for embedding active components such as micro chips.
The composite build-up materials comprise a carrier layer (1), a resin layer with reinforcement (2), and a resin layer without reinforcement (3). The active component (6) is embedded into the resin layer without reinforcement (6).

## Description

### Field of the Disclosure

The invention relates to build-up materials for the manufacture of printed circuit boards, IC substrates, chip packages and the like which are suitable for embedding active electronic components, such as micro-chips.

### Background of the Invention

Historically, active components such as micro-chips are mounted on one or both outer surfaces of the substrates, such as printed circuit boards, IC substrates, chip packages and the like. However, the continuing need to reduce the size of such substrates requires to embed the active components into the substrates themselves and so achieve even further gains in size reduction. Furthermore, an increase in the density of the active components on a circuit board results in a significant improvement in performance due to shorter current paths and lower "noise", i.e. random fluctuations in an electrical signal. Another aspect of active component embedding is the reduction of total assembly costs in printed circuit board and chip package manufacture.

The active components can be embedded at different stages of the production process. Three main strategies for embedding active components are known in the art: 1. the chip-first method, 2. the chip-middle method and 3. the chip-last method (see for example R. R. Tummala, M. Swaminathan, "Introduction to Systems On-Package (SOP)", 1st Ed., McGraw-Hill, 2008, pp. 430-434).

The requirements for substrate composite build-up materials suitable for embedding active components are manifold. The coefficient of thermal expansion (CTE) of composite build-up materials needs to be as close as possible to those of the other materials used in a typical build-up, such as metals like copper, polymers and silicon.

Build-up materials used for embedding active components are, for example, resin coated foils (RCF). For the production of high density interconnect (HDI) printed circuit boards (PCB) having embedded active components the use of RCF is a standard technique (Printed circuits handbook, Ed. Clyde F. Coombs Jr., 6th ed, chapter 22). First, the inner layers of the printed circuit board are manufactured and then the RCF is laminated onto them. This manufacturing step is carried out in a vacuum press. The b-staged resin of the RCF melts at elevated temperatures and flows to fill out the spaces in between the copper tracks of the innerlayer. The resin is then cured at still higher temperatures and when the pressing cycle is finished, microvias are created in the cured resin layer by milling, spark ablation, plasma, or preferably laser drilling processes.

The CTE of RCF materials is rather high which is a severe disadvantage, e. g. in thermal cycling tests and solder dip tests (relevant test procedures include for example JESD22-A104-B, J-STD-003A). Furthermore, the required co-planarity of the whole assembly with embedded chips can not always be reached if RCF materials are used for the build-up. Another disadvantage of RCF materials is their residual volatile organic compounds content (VOC), because the manufacturing process of the substrate materials usually involves one or more solvent-based coating steps.

Another type of build-up materials used for embedding of active components are reinforced resin coated foils (RRCF) which typically have a glass fabric as reinforcement embedded within the b-staged resin. This type of composite build-up materials has the advantage of a considerably lower CTE and a higher dimensional stability compared to RCF build-up materials. The increased dimensional stability prevents cracking of the resin during lay-up, with the result that the reliability of the finished HDI board or IC substrate is improved. However, it is difficult to laser drill the microvias through the glass fabric, which significantly increases production times and therefore cost. Another disadvantage of RRCF materials is their high residual VOC content because, like RCF materials, the manufacturing process typically involves one or more solvent-based coating steps.

A third type of build-up materials used for embedding of active components are prepregs which are pressed on top of the innerlayers together with separate copper foils on top of the prepregs. The handling of the sensitive prepregs is problematic, because the brittle prepreg material can chip away at the edges, for example during transport. The edge chips end up in unwanted places in the laminating press. Furthermore, laser drilling of microvias and through holes is more difficult due to the reinforcement embedded in the prepreg. Another disadvantage of prepregs is the fact that openings of the size of the chips must be created (e. g. by laser cutting) in the prepreg before embedding of the active component and pressing of the whole assembly. This additional step and the registration problems linked with smaller chip geometries are serious shortcomings of that approach. Another disadvantage of prepreg materials is their VOC content because the manufacturing process of the substrate materials may comprise one or more solvent-based coating steps.

### Object of the Invention

It is therefore an objective of the present invention to provide composite build-up materials for embedding active components which prevent the disadvantages of RCF, RRCF and prepreg material currently used for embedding of active components. The objects of the present invention are to provide composite build-up materials having a low VOC content and which possess a high co-planarity and dimensional stability after embedding of the active component. Furthermore, such composite build-up materials should be obtained by a manufacturing process with reduced process steps. In addition, the build-up material should not be brittle and easy to handle during manufacturing and in successive manufacturing steps. Vias and the like should be easily formed in the composite build-up material after embedding of active components. The composite build-up material should have an improved mechanical stability which enables also embedding of larger active components.

### Summary of the Invention

These objectives are solved with composite build-up material suitable for embedding active components, the composite build-up material having a layer sequence in the following order
(i) a carrier layer having a thickness of 1 to 400 µm,
(ii) a resin layer with reinforcement having a thickness of 1 to 200 µm and
(iii) a resin layer without reinforcement having a thickness of 1 to 500 µm.

The resin layer without reinforcement is capable of hosting embedded active components. After embedding of the active component the composite build-up material according to the present invention provides sufficient mechanical stability and a high co-planarity of the whole assembly due to a reinforced resin layer. Furthermore, embedding of active components needs less production steps when using the composite build-up materials according to the present invention.

Active components are electronic components activated by an external source of power. Active components are for example micro-chips, transistors, diodes and other integrated circuits.

Due to the improved mechanical stability of the build-up material according to the present invention caused by the reinforced resin layer, the thickness of the resin layer without reinforcement can be increased compared to build-up materials known in prior art. The increased thickness of the resin layer without reinforcement allows also embedding of larger, especially thicker active components into the build-up material while still keeping a high co-planarity of the whole assembly.

### Brief Description of the Figures

Figure 1 shows a composite build-up material according to the present invention suitable for the embedding of active components.
Figure 2 shows a composite build-up material according to the present invention with an embedded active component.
Figure 3 shows a composite build-up material according to the present invention suitable for the embedding of active components containing a release layer between the carrier layer and the resin layer with a reinforcement.
Figure 4 shows a composite build-up material according to the present invention suitable for the embedding of active components containing a primer layer.
Figure 5 shows a micrograph of a cross-sectioned composite build-up material derived from the example.
   1 Carrier layer
   2 Resin layer with reinforcement
   3 Resin layer without reinforcement
   4 Release layer
   5 Primer layer
   6 Embedded active component
   7 Embedded active component dummy
   8 Structured laminate

### Detailed Description of the Invention

The composite build-up material according to the present invention has a layer sequence in the following order
(i) a carrier layer (1) having a thickness of 1 to 400 µm,
(ii) a resin layer with reinforcement (2) having a thickness of 1 to 200 µm and
(iii) a resin layer without reinforcement (3) having a thickness of 1 to 500 µm.

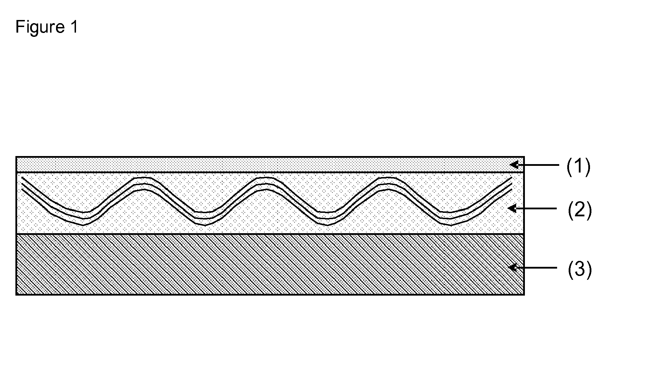

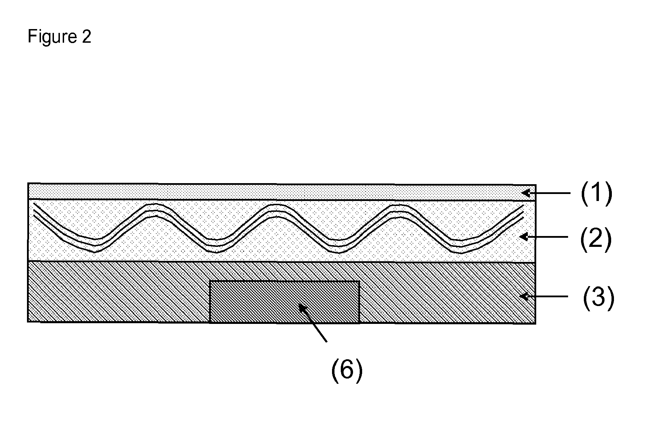

The carrier layer (1) consists, for example of a copper foil, on which a resin with a reinforcement (2) is attached. The next layer (3) consists of a resin without a reinforcement. This is illustrated in Fig. 1. Said composite build-up material is useful for the embedding of active components such as micro-chips. For that purpose the composite build-up material is pressed on the active component with layer (3) facing to the active component (Fig. 2). The resulting assembly consisting of the composite build-up material and the embedded active component (6) has a high mechanical stability and a high co-planarity.

After press-lamination of the build-up composite structure onto the active component (embedding step), the carrier layer (1) is structured and microvias are formed and connections made to the contacts on the surface of the chip.

In another embodiment of the present invention the carrier layer (1) is removed from the build-up material after embedding of active components.

The chemical nature of the resins used in the layers (2) and (3) can be the same or different. It is possible to adjust the formulation for each of the layers (2) and (3) according to the desired property profile. For example, the resin formulation of layer (3) can be adjusted to have an extremely low modulus, so that it can act as a strain buffer. The formulation of the resin layer without reinforcement (3) can also be adjusted to have a good adhesion to active components having different surface treatments, for example silicon nitride (disclosed in US 2006/014377 A1), silicon oxynitride (disclosed in WO03/046253A1), silicon carbide (disclosed in WO2007/081528A2), gallium nitride and aluminium nitride (disclosed in WO2010/020066A1). The resin used in the resin layer (2) can for example be optimized in its composition to achieve optimum wetting of the reinforcement. It is also important that the melt viscosity of the resin layer (2) after b-staging is not too high which prevents penetration of the reinforcement necessary for good embedding and to prevent voids, yet not too low as to cause excessive flow-out during the press-lamination step.

The resins of layer (2) and (3) are preferably applied by a solvent-free coating process. In a solvent-free coating process the resin material is used in form of a solvent-free resin powder. The advantage of solvent-free coating of layer (3) is that no bubbles from evaporating solvent are formed under the reinforcement of layer (2). It is well known in the art that residual solvent causes undesired voids on pressing and curing in later processing steps. Furthermore, solvent-free processes lead to a composite build-up material having a reduced VOC content. Suitable technologies for solvent-free coating processes of resin layer without reinforcement (3) include but are not restricted to direct melt extrusion, scattering of a resin powder using a rotating scattering drum, electromagnetic brush (EMB) application of a resin powder and the electrostatic spraying of a resin powder using corona or triboelectric charging techniques.

The use of a resin powder scattering drum process and the use of direct melt extrusion process are the most preferred methods of solvent-free coating resin layers (2) and (3).

Suitable materials for carrier layer (1) are metals such as copper, aluminium, tin, paper, polymer foils made of polymers selected from the group consisting of polyethylene therephthalate (PET), polyethylene naphthalate (PEN), polyimide, polyether ether ketone (PEEK), cyclic olefin copolymer (COC), polyamide, polytetrafluoroethylene (PTFE), fluorinated ethylene propylene (FEP), ethylene tetrafluoroethylene (ETFE), THV (co-polymer of tetrafluoroethylene, hexafluoropropylene and vinylidene fluoride), polychlorotrifluoroethylene (PCTFE), polyvinylfluoride (PVF), polyvinylidene fluoride (PVDF), perfluoro alkoxy (PFA), MFA (co-polymer of tetrafluoroethylene and per-fluoro vinylether), polyarylate, ECTF ethylene-chlorotrifluoroethylene (ECTFE), polyethersulfone (PES), polymethylpentene (PMP), polyetherimide, polysulfone, and crosslinked polymer foils such as X-HDPE.

The carrier layer consists preferably of a material which can withstand temperatures in the range of 150-250 °C which are applied during the pressing step. Said temperature depends on the resin type used.

The carrier layer (1) is most preferably selected from the group consisting of copper foil, aluminium foil, polyethylene naphthalate (PEN) foil, cyclic olefin co-polymer (COC) foil, polyarylate foil, polyethersulfone (PES) foil, polyetherimide foil, and polysulfone foil.

The thickness of the said carrier layer (1) ranges from 1 µm to 400 µm, more preferably from 5 µm to 200 µm and most preferably from 10 µm to 100 µm.

The composite build-up material according to the present invention contains a resin layer with a reinforcement (2) on top of the carrier layer (1).

Resin materials suitable for use in resin layer with reinforcement (2) and resin layer without reinforcement (3) are independently selected from the group consisting of epoxy resins, cyanate ester resins, bismaleimide resins, bismaleide triazine resins, benzoxazine resins, and mixtures thereof.

Epoxy resins suitable as resin material of resin layer with reinforcement (2) and resin material of resin layer without reinforcement (3) are independently selected from the group comprising bisphenol-A-based epoxy resins, bisphenol-F-based epoxy resins, epoxy resins based on 3,3',5,5'-tetrabromobisphenol-A, phenolic novolac epoxy resins, novolac-modified bisphenol A epoxy resins such as D.E.R.6508 available from Dow Chemicals, cresol novolac epoxy resins, phosphorous-modified epoxy resins, diacid-modified epoxy resins, epoxysilane modified epoxy resins such a KSR-900 from Kukdo Chemicals, multifunctional epoxy resins such as 2,2',2",2"'-[1,2-ethanediylidenetetrakis(4,1-phenyleneoxymethylene)] tetrakis oxirane (CAS-no. 7328-97-4), the glycidylether of the polymer of phenol with 3a,4,7,7a-tetrahydro-4,7-methano-1H-indene (CAS-no. 119345-05-0), 4,4'-bis(2,3-epoxypropoxy)-3,3',5,5'-tetramethylbiphenyl (CAS-no. 85954-11-6), bis(2,3-epoxypropoxy)-biphenyl, trisglycidylisocyanurate, Epiclon HP-4032, Epiclon HP-820, Epiclon HP-4700, Epiclon HP-4770, Epiclon EXA 1514, Epiclon EXA 4816, Epiclon EXA 4822 resins available from DIC Europe GmbH, isocyanate-modified epoxy resins such as AER 4152, AER 5100, XAC 4151, available from Asahi Kasei Co., glycidyl esters of multifunctional aromatic carboxylic acids such as trimellitic acid and terephthalic acid, rubber-modified epoxy resins such as the reaction products of carboxy-terminated polybutabdiene and carboxy-terminated polybutadiene-acrylonitrile copolymers with bisphenol A epoxy resin and bisphenol F epoxy resins and mixtures of the aforementioned.

Preferred resin materials for the resin layer with reinforcement (2) and resin layer without a reinforcement (3) are independently selected from formulations containing epoxy resins and epoxy resin blend formulations comprising one or more of bisphenol-A-based epoxy resins, epoxy resins based on 3,3'5,5'-tetrabromobisphenol-A, phenolic novolac epoxy resins, novolac-modified bisphenol A epoxy resins such as D.E.R.6508, cresol novolac epoxy resins, epoxy resins modified by reaction with 9,10-dihydro-9-oxa-10-phosphaphenanthrene-10-oxide, KSR-900, multifunctional epoxy resins such as 2,2',2",2"'-[1,2-ethanediylidenetetrakis(4,1-phenyleneoxymethylene)] tetrakis oxirane, the glycidylether of the polymer of phenol with 3a,4,7,7a-tetrahydro-4,7-methano-1H-indene, 4,4'-bis(2,3-epoxypropoxy)-3,3',5,5'-tetramethylbiphenyl, bis(2,3-epoxypropoxy)-biphenyl, Epiclon HP-4032, Epiclon HP-4700, Epiclon HP-4770, Epiclon EXA 1514, isocyanate-modified epoxy resins such as AER 4152, AER 5100, XAC 4151, rubber-modified epoxy resins such as the reaction products of carboxy-terminated polybutabdiene and carboxy-terminated polybutadiene-acrylonitrile copolymers with bisphenol A epoxy resin and bisphenol F epoxy resins, cyanate ester resins, bismaleimide resins, bismaleimide triazine resins (BT), benzoxazine resins and mixtures thereof.

Most preferred resin material for the resin layer with reinforcement (2) and resin layer without a reinforcement (3) are independently selected from formulations containing epoxy resins and epoxy resin blend formulations comprising one or more of phenolic novolac epoxy resins, novolac-modified bisphenol A epoxy resins such as D.E.R.6508, cresol novolac epoxy resins, epoxy resins modified by reaction with 9,10-dihydro-9-oxa-10-phosphaphenanthrene-10-oxide, multifunctional epoxy resins such as 2,2',2",2"'-[1,2-ethanediylidene tetrakis-(4,1-phenyleneoxymethylene)], tetrakis-oxirane, the glycidylether of the polymer of phenol with 3a,4,7,7a-tetrahydro-4,7-methano-1H-indene, Epiclon HP-4032, Epiclon HP-4700, Epiclon EXA 1514, isocyanate-modified epoxy resins such as AER 4152, AER 5100, XAC 4151, rubber-modified epoxy resins such as the reaction products of carboxy-terminated polybutabdiene and carboxy-terminated polybutadiene-acrylonitrile copolymers with bisphenol A epoxy resin, cyanate ester resins, bismaleimide resins, bismaleimide triazine resins (BT), benzoxazine resins and mixtures thereof.

Epoxy resins usually contain at least one hardener which reacts with the epoxy resin component to form a polyepoxide polymer. Suitable hardeners for use with epoxy resins in resin layer with a reinforcement (2) and resin layer without a reinforcement (3) are independently selected from the group comprising amines, cycloaliphatic amines, C₁-C₆- alkylated 4,4'-methylene-bis-anilines, C₁-C₆ alkylaryldiamines, anhydrides, multifunctional carboxylic acids, carboxy-functional polymers, isocyanates, blocked isocyanates, cyanate esters and multifunctional phenolic compounds, novolac resins, alkylphenol-formaldehyde novolac resins, borontrifluoride-amine adducts, epoxide-amine adducts and mixtures thereof.

In a preferred embodiment the resins in resin layer with reinforcement (2) and resin layer without reinforcement (3) are epoxy resins and the hardeners are independently selected from the group consisting of dicyandiamide, substituted dicyandiamide, phenol-formaldehyde novolac resins, cresol-formaldehyde novolac resins, triazine-substituted phenol-formaldehyde novolac resins, such as the Phenolite ATN series of compounds available from DIC Corp., tris-phenol novolacs (available as Resicure 3500, CAS-no. 225241-86-1), 3,3'-diaminodiphenyl sulphone, 4,4'-diaminodiphenyl sulphone, 4,4'-methylene-bis-(2,6-diethylaniline), dialkylaryldiamines, nadic methyl anhydride, phthalic anhydride, methyl phthalic anhydride, cyanate esters, ortho-toluylbiguanide and mixtures thereof.

Most preferred hardeners for use with epoxy resins in resin layer with reinforcement (2) and resin layer without reinforcement (3) are independently selected from the group consisting of dicyandiamide, phenol-formaldehyde novolac resins, cresol-formaldehyde novolac resins, triazine-substituted phenol-formaldehyde novolac resins such as the Phenolite ATN series of compounds available from DIC Corp., tris-phenol novolacs, cyanate esters, orthotoluyl-biguanide and mixtures thereof.

The amount of hardener used with the epoxy resin in resin layer with reinforcement (2) and resin layer without reinforcement (3) is determined independently largely of the equivalent weights of the total epoxides and the equivalent weight of the total hardeners, with the ratio of the equivalents of epoxide: hardener independently for the epoxy resin in the resin layer with reinforcement (2) and the resin layer without reinforcement (3) selected in a range from preferably 0.5:1 to 1:0.5, more preferably from 0.7:1 to 1:0.7 and most preferably from 1:1 to 1:0.75.

The resin of the resin layer with reinforcement (2) and the resin of the resin layer without reinforcement (3) are most preferably epoxy resins and the hardener in the resin of the resin layer with reinforcement (2) and the resin of the resin layer without reinforcement (3) are independently selected from the group consisting of phenolic resins, dicyandiamide, derivatives of dicyandiamide, 4,4'-diaminophenylsulphone and mixtures thereof.

A catalyst initiates the reaction of epoxy resins used in the resin layer with a reinforcement (2) and the resin layer without reinforcement (3) with hardeners such as the above described. Useful are catalysts that have a good thermal latency as this enables thorough mixing and blending of the reactive components of the resin layer, coating and levelling of the formulation to be carried out without triggering the crosslinking reaction prematurely. Such latent catalysts include, without being restricted to triphenyl phosphine, tetraphenylphosphonium tetraphenylborate, triphenylphosphine-1,4-benzoquinone adduct, the combination of aliphatic amines, aromatic amines and imidazoles with weak acids such as cyanuric acid, lactic acid, C₁-C₁₂ carboxylic acids, maleic acid, terephthalic acid, citric acid, boric acid, phenyl boronic acid, benzoic acid, trimellitic acid, tartaric acid and the like. The imidazoles for use both with or without weak acids can be unsubstituted or substituted in the 1-position by C₁-C₁₈ alkyl, C₆-C₁₀ aryl and benzyl, cyanoethyl, -(CH₂)ₙ-CO₂-(C₁-C₁₂ alkyl), (2,4-diaminotriazinyl-1-)-ethyl, and can be: unsubstituted or substituted in the 2-position by C₁-C₁₈ alkyl, C₆-C₁₀ aryl, benzyl, additionally the substituents at the 1 and 2 positions can together form a 5 or 6-membered fused ring and can independently of one another be: unsubstituted or substituted at the 3 and 4 positions by C₁-C₁₈ alkyl, hydroxyl, C₁-C₁₂ alkoxy, hydroxymethyl, hydroxyethyl, C₁-C₁₂ alkylcarboxyalkyl, additionally the substituents at the 3 and 4 positions can together form a fused benzene ring or fused 5 or 6-membered cycloalkyl ring. Other latent catalysts for use in epoxy resin systems independently constituting the resin of layer (2) and the resin of layer (3) include the urone latent catalysts, epoxy-amine adducts and urea derivatives such as the Omicure U series and Omicure B series of products available from CVC Specialty Chemicals.

Preferred latent catalysts for use with epoxy resin systems in resin layer with reinforcement (2) and resin layer without reinforcement (3) are selected independently from the group consisting of 6-[2-(2-methyl-1H-imidazol-1-yl)ethyl]-1,3,5-triazine-2,4-diamine optionally complexed with 1,3,5-triazine-2,4,6(1 H, 3H, 5H)-trione and optionally containing one molecule of water of crystallization available from Shikoku Chemicals under the name Curezol 2MA-OK, urone catalysts such as Dyhard UR 200, Dyhard UR 300, Dyhard UR 500, the substituted ureas such as Dyhard URAcc 13 and Dyhard URAcc 43, from Evonik Corp., amine adducts with epoxy compounds such as Ajicure PN-23, Ajicure PN-H, Ajicure PN-31, Ajicure PN 40, Ajicure MY-24, Ajicure MY-23, Ajicure MY-H, Amine-epoxy adduct complexes such as Ajicure AH-203, Ajicure AH-300, DICY complexes such as Ajicure AH-154, Ajicure AH-162 and dihydrazide compounds such as Ajicure VDH from the Ajinomoto Co. and mixtures thereof.

Most preferred catalysts for epoxy systems in resin layer with reinforcement (2) and resin layer without reinforcement (3) with good latency are selected independently from the group consisting of Curezol 2MA-OK, Ajicure PN-23, Ajicure MY-24, Dyhard URAcc43, imidazole substituted in the 1-position by H, C₁ - C₁₈ alkyl, cyanoethyl, substituted in the 2-position by H, methyl, phenyl, substituted at the 3 and 4 positions by H, methyl, hydroxyl, -CH₂OH, additionally the substituents at the 3 and 4 positions can together form a fused benzene ring and optionally complexed with C₁-C₆ carboxylic acids, terephthalic acid, boric acid, phenyl boronic acid, benzoic acid, trimellitic acid and mixtures thereof.

Such catalysts as described above are used in concentrations in the range 0.01-20 wt.-%, preferably 0.02-5 wt.-% and most preferably 0.02-1 wt.-%.

When cyanate esters are used in the resin layer with reinforcement (2) and resin layer without reinforcement (3), the use of a metal catalyst is preferable. Suitable catalysts include the metal salts of Cu(I), Co(II), Fe(II) and Mn(II) with organic acids, which may for convenience be dissolved in non-volatile solvents, such as nonylphenol.

The preferred concentration of such metal catalysts is 5-500 ppm, preferably 20-100 ppm and most preferably 30-60 ppm of metal ion with respect to the total resin content without taking the optional filler into account.

Additionally the resin layer with reinforcement (2) and the resin layer without reinforcement (3) may contain independently one or more antioxidants, flame retardants, wetting agents, optical brighteners, adhesion promoters, surfactants, leveling agents, pigments, dyes, non-reactive polymers, elastomers, tougheners, impact modifiers, ion-capturing agents, degassing agents, disperants, metal complex catalysts and rheology agents.

Flame retardants include but are not restricted to one or more of melamine derivatives, phosphorus compounds, borates, magnesium hydroxide, aluminium hydroxide, antimony trioxide, antimony pentoxide, phosphorus esters, tetrabromobisphenol, 9,10-dihydro-9-oxa-10-phosphaphenanthrene-10-oxide, bisphenol A-bis (diphenyl phosphate), alkyl-, chloroalkyl- and aryl- esters of phosphoric acid, melamine phosphate, melamine cyanurate, poly(m-phenylene methylphosphonate), ammonium polyphosphate, masterbatches of red phosphorous in an organic polymer or resin, 10-(2,5-dihydroxyphenyl)-10H-9-oxa-10-phospha-phenantbrene-10-oxide (CAS-no. 99208-50-1).

Preferred flame retardants are melamine derivatives, phosphorus compounds, tetrabromobisphenol, 9,10-dihydro-9-oxa-10-phosphaphenanthrene-10-oxide, melamine cyanurate, poly(m-phenylene methylphosphonate), ammonium polyphosphate, and 10-(2,5-dihydroxyphenyl)-10H-9-oxa-10-phosphaphenantbrene-10-oxide.

The reinforcement of the resin layer with a reinforcement (2) is selected from the group comprising woven and non-woven fabrics of materials selected from the group consisting of silica glass, silica glass containing metal oxides of group 1 metals, silica glass containing metal oxides of group 2 metals, silica glass containing metal oxides of group 1 metals and group 2 metals, E-glass, alumino silicates, silicon nitride, boron nitride, Wollastonite, ceramic oxides, aramides, such as Kevlar^{®} and mixtures thereof.

Preferably, the reinforcement consists of aramide fiber or E glass, the composition range of which is described in section 3.1.6 of the IPC document 4412 (May 2002 version).

The surface of the reinforcement is preferably modified with silane adhesion promoters, most preferably with epoxy silanes and amino silanes.

Examples of suitable woven glass styles include but are not restricted to those listed in the IPC-4412A Amendment 1 (March 2008 version) and the glass style 7630, 1074, 1013, 0809, 1555, 1010.

Preferred glass fabric styles are 1015, 1017, 1027, 106, 1080, and 1037.

Examples of suitable non-woven glass fabrics include but are not restricted to glass fiber tissue such as AG H 35, AG H 55, AG H 70, AG H 75, AG H 100, AG H 105 and the like which are available from Saint-Gobain Vetrotex International S.A. and flat glass fiber sheet available from Nitto Boseki Co. Ltd.

Example of suitable organic fibers include but are not restricted to non-woven Aramid reinforcement such as type 2.0N710, 3.0N710 and 4.0N710 from Du-Pont.

The thickness of the cured resin layer with reinforcement (2) ranges from 1 µm to 200 µm, more preferably from 5 µm to 150 µm and most preferably from 10 µm to 100 µm.

Optionally, the resin of resin layer with reinforcement (2) and the resin of resin layer without reinforcement (3) contain independently from each other filler particles such as aluminium oxide, fused silica, fumed silica, boron nitride, barium sulfate, calcium carbonate, aluminium hydroxide, antimony pentoxide, antimony trioxide, apatite, carbon black, attapulgite, barium titanate, bentonite, beryllium oxide, calcium sulfate, clay, cristobalite, dolomite, feldspar, metal oxides, kaolin, magnesium oxide and the like.

Said filler particles are utilized in one embodiment of the present invention to reduce the CTE of the resin layer with reinforcement (2) and/or of resin layer without reinforcement (3) even more or increase the heat conductivity of resin layer with reinforcement (2) and/or resin layer without reinforcement (3).

The most preferred filler particles for the resin layer with reinforcement (2) and the resin layer without reinforcement (3) are independently selected from the group consisting of aluminium oxide, fused silica, fumed silica and boron nitride.

The use of optional fillers for both resin layer with reinforcement (2) and resin layer without reinforcement (3) having spherical shape or having an aspect ratio in the range of 1:1-1:1.5 is most preferred.

In order to improve the cohesive strength of the resin layer with reinforcement (2) and/or of the resin layer without reinforcement (3) and to improve the water impermeability of said layers it is preferred to modify the surface of the optional fillers using organic alkoxysilanes, epoxysilanes, aminosilanes, mercaptosilanes, acetoxysilanes and azasilanes. In the case of the alkoxysilanes and acteoxysilanes, these hydrolyse in the presence of moisture to form the corresponding reactive silanols, which then condense with hydroxyl groups on the surface of the fillers with the liberation of water. The fillers can be either pretreated with silanes or the silane added to the mixture during mixing or processing. A comprehensive treatise on the methods of surface modification of fillers using silanes and azasilanes can be found in the Internet publication "Silane Coupling Agents: Connecting across Boundaries" by Barry Arkles on the website www.gelest.com.

If a solvent-free coating method for the application of the resin layer with reinforcement (2) and/or resin layer without reinforcement (3) is used, it is preferred to either use an already-surface-treated filler or to carry out the addition of the surface modification agent in the extrusion blending step. Suitable surface modification agents are include but are not restricted to one or more epoxy silanes such as 2-(3,4-epoxycyclohexyl)ethyltriethoxy silane, 2-(3,4-epoxycyclohexyl)ethyltrimethoxy-silane, (3-glycidoxypropyl)trimethoxysilane, (3-glycidoxypropyl)triethoxysilane, 5,6-epoxyhexyltriethoxysilane, (3-glycidoxypropyl)methyldiethoxysilane, (3-glycidoxypropyl)methyldimethoxysilane, (3-glycidoxypropyl)dimethylethoxysilane, aminosilanes such as 3-aminopropyltriethoxysilane, 3-aminopropyl-trimethoxysilane, aminophenyltrimethoxysilane, 3-aminopropylmethyldiethoxysilane, 3-aminodimethyl-ethoxysilane, N-(2-aminoethyl)-3-aminopropyltrimethoxysilane, N-(2-aminoethyl)-3-aminopropyltriethoxysilane, (3-trimethoxy-silylpropyldiethylenetriamine, n-butylaminopropyltrimethoxysilane, N-ethylamino-isobutyltrimethoxysilane, N-ethylaminopropyltrimethoxysilane, (N,N-diethyl-3-aminopropyltrimethoxysilane, bis(3-trimethoxysilylpropyl)amine, bis[(3-trimethoxysilyl)propyl]-ethylenediamine, 3-mercaptopropyltrimethoxysilane, 3-mercaptopropylmethyldimethoxysilane, hexadecyltrimethoxysilane, octyltrimethoxysilane, isobutyltrimethoxysilane, phenyltrimethoxysilane, bis(triethoxysilyl)ethane, tris(3-trimethoxysilylpropyl)isocyanurate, bis[3-(triethoxysilyl)propyl]urea, (3-acryloxypropyl)trimethoxysilane, methacryloxypropyltrimethoxysilane, n-butyltrimethoxysilane, hexamethyldisilazane, N-n-butylaza-2,2-dimethoxysilacyclopentane, 1,3-divinyltetramethyldisilazane, vinyldimethylethoxysilane, styrylethyltrimethoxysilane, vinyltrimethoxysilane.

The optimum amount of silane, azasilane or silanol added to the filler is a quantity sufficient to form a monolayer on the surface of the filler and that has reacted with all of the surface hydroxyl groups of the filler. This quantity is typically in the range 0.01-5 wt.-% with respect to the filler, preferably 0.05-2 wt.-% and most preferably 0.1-1.5 wt.-%.

The composite build-up material according to the present invention contains a resin layer without reinforcement (3) attached to the resin layer with reinforcement (2) (Fig. 1).

The thickness of the cured resin layer without reinforcement (3) ranges from 5 µm to 500 µm, more preferably from 10 µm to 300 µm and most preferably from 20 µm to 200 um.

In one embodiment of the present invention the resin materials used for resin layer with a reinforcement (2) and resin layer without a reinforcement (3) are the same.

One technical advantage when using the composite build-up material for embedding of active components compared to build-up materials for said purpose known in the art is as follows. To achieve the same property profile of an embedding layer in combination with a reinforcement layer by conventional means causes the production process to be much longer and time-consuming. In a sequential procedure a resin coated foil has to be press-laminated on the chip, the foil has to be removed (normally by etching), and in a following step a prepreg with a copper foil has to be press-laminated on top of that construction. This additional step of press-lamination is a significant cost driver in production. Furthermore, the batch-wise process of lamination in a vacuum press means a lot of additional manual work for lay-up of the press book. This type of press also takes up a lot of space in the costly clean-room environment.

Another advantage of the claimed composite build-up material is that it allows rather thick embedding layers to be used. The conventional resin coated foils (RCF) have maximum resin thicknesses of about 70 µm. At higher thickness the resin layer becomes normally too sensitive mechanically and tends to crack. Manufacturing and handling become very difficult or virtually impossible. Surprisingly when the resin layer without a reinforcement (3) is used in combination with the resin layer with a reinforcement (2) as in the inventive composite build-up material, the reinforced resin layer (2) can absorb much of the stress and therefore the non-reinforced resin layer (3) can be made thicker without cracks occurring.

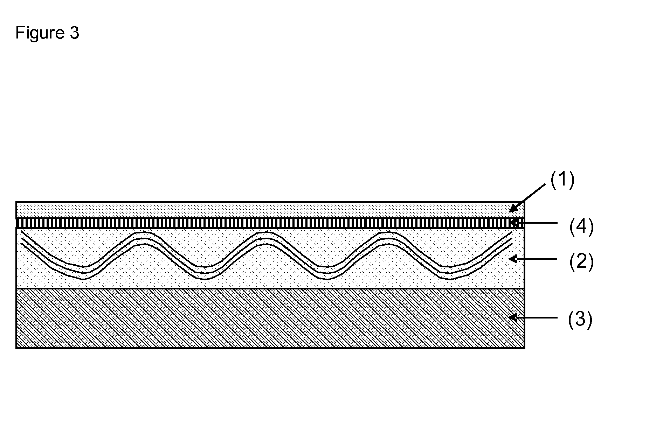

In one embodiment of the present invention as shown in Fig. 3 the composite build-up material suitable for embedding active components has a layer sequence in the following order of
(i) a carrier layer (1) having a thickness of 1 to 400 µm,
(ii) b) a release layer (4),
(ii) a resin layer with reinforcement (2) having a thickness of 1 to 200 µm and
(iii) a resin layer without reinforcement (3) having a thickness of 1 to 500 µm.

A release layer (4) is deposited onto carrier layer (1) that enables easy detachment of the carrier layer (1) together with the release layer (4) from the resin layer with reinforcement (2) after embedding of the active components. This easy release is especially important when the carrier layer itself has no function in the final electronic assembly other than providing mechanical stability during manufacture of the composite build-up material. In that case the carrier layer (1) can easily be peeled off from the substrate after press-curing.

In the semi additive process (SAP) for manufacture of printed circuit boards, IC substrates and the like the carrier layer (1) is not required for forming conductive tracks. Instead, the carrier layer (1) can be fully removed by etching (if metal) in an acidic bath or by peeling-off. Thereafter in both cases a very thin layer of electroless copper is deposited onto the surface of resin layer with reinforcement (2), a resist is then applied on the thin copper layer, the resist is developed, the open copper is then electrolytically built up, the resist is stripped, and a flash-etch step removes the thin copper layer from the beginning at the positions where no galvanic copper was deposited. In this case, the carrier layer (1) is only needed for the transfer of the resin layers (2) and (3) to the electronic assembly before pressing the electronic assembly.

Suitable release layers (4) are selected from the group consisting of silicones such as polydimethylsiloxane (PDMS), hydrocarbon oils, waxes, crosslinked silicone polymers, crosslinked polymers based on acrylates and vinyl monomers, vinyl polymers, cured epoxy resins, polyurethanes, polyamides, polyesters, polyolefins, sol-gel coatings based on silanes and silazanes, fluorinated polymers such as polytertafluoro ethylene (PTFE), and molecular materials such as heterocyclic compounds containing at least one thiol group, e.g., 1 H-1,2,4-triazole-3-thiol (1,2,4-triazole-3-thiol, 3-mercaptotriazole, CAS No. 3179-31-5), 3-amino-1,2,4-triazole-5-thiol (3-amino-5-mercapto-1,2,4-triazole, CAS No. 16691-43-3), 2-mercaptobenzothiazole and 2-mercaptobenzimidazole. Said release layer (4) forming heterocyclic compounds containing at least one thiol group are used for deposition onto the carrier layer (1). For said purpose, such compounds are dissolved in a suitable solvent such as water in a concentration in the range of 1 mg/l to 1000 mg/l. Most preferred release layers (4) are sol-gel coatings based on silanes, crosslinked silicone polymers, crosslinked polymers based on acrylates and vinyl monomers.

In another embodiment of the present invention the composite build-up material suitable for embedding active components has a layer sequence in the following order of
(i) a carrier layer (1) having a thickness of 1 to 400 µm,
(ii) b) a primer layer (5),
(ii) a resin layer with reinforcement (2) having a thickness of 1 to 200 µm and
(iii) a resin layer without reinforcement (3) having a thickness of 1 to 500 µm.

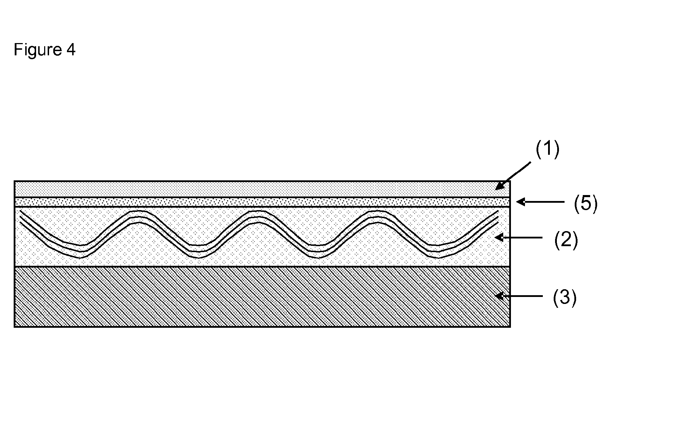

The carrier foil (1) can also be endowed with a primer layer (5) before the resin layers (2) and (3) are applied (see Figure 4). This primer layer remains adhering to the dielectric layer after press-lamination and curing. The primer layer (5) is made of a resin formulation having especially good adhesion to copper which is important when the carrier layer (1) remains part of the final assembly.

The primer layer (5) consists of a resin material having a Tg value of 50-300 °C, preferably 80-250 °C, most preferably 130-220 °C, as determined by DSC (IPC TM-650 2.4.25).

The components of said primer layer are selected from the same components used in resin layers (2) and (3) but formulated for optimum adhesion in case a copper foil is used as a carrier layer (1).

An optional primer layer (5) is preferred if the carrier layer (1) is made of a metal such as copper, aluminium and tin.

An optional primer layer (5) is also preferred when the carrier layer (1) is not removed from the built-up assembly in a later process step.

The thickness of the said primer layer (5) ranges from 1 µm to 20 µm, more preferably from 2 µm to 10 µm and most preferably from 3 µm to 5 µm.

The primer layer (5) can be applied as a powder by electrostatically spraying, by an electro magnetic brush process, powder scattering or from the melt by direct extrusion.

In one embodiment of the present invention, the primer layer (5) is preferably coated from solution by curtain coating, slot coating, roller transfer coating, dip coating, spraying, spin coating, most preferably by curtain coating and slot coating. For the purposes of the solvent coating the use of surface active agents such as non-ionic and anionic surfactants, acrylates, fluorinated surfactants and silicones is useful. Suitable solvents for use with the primer include but are not restricted to dichloromethane, dichlorethane, acetone, methylethylketone, ethyl acetate, butyl acetate, methanol, ethanol, propanol, butanol, isobutanol, ethylene glycol, ethylene carbonate, propylene carbonate, glycerolcarbonate, N-methyl formamide, N-methylpyrollidone, N-ethylpyrollidone, benzene, toluene, xylene, cellosolves, carbitols, tetrahydrofuran, ethoxyethylproprionate, benzyl alcohol, cyclohexanone, dimethylsulphoxide, hexane, heptane, octane, nonane, petroleum ether, cyclohexane and mixtures therof.

The manufacturing of the composite build-up materials suitable for embedding active components is described in the following:
A carrier layer (1) (e.g., a copper foil) is coated in a first step with a resin formulation, preferably in a continuous reel-to-reel process. Said resin will later form the resin layer with a reinforcement (2). The resin material is dissolved in a suitable solvent and applied in a wet coating process to the carrier layer (1), e. g., by using a comma coater, a slot coater, bar coater, curtain coater, by spraying or dip coating.

In another, and preferred embodiment the resin of resin layer with a reinforcement (2) and the resin of resin layer without reinforcement (3) are formulated without the use of solvents as solvent-free resin powders and coated by means of a solvent-free method selected from the group comprising powder spraying, electromagnetic brush (EMB) process, powder scattering process and direct melt extrusion process.

For solvent-free coating, standard production equipment used commercially for the production of powder coatings is suitable for the formulation step, as described in chapter 4 of the book "Powder Coatings Chemistry and Technology" by Pieter Gillis de Lange, 2004 and published by C.H.I.P.S., Texas. The dry resins, fillers and additives are weighed out and mixed together to form a premix using a suitable mixer. Examples of suitable mixers are conical mixers, drum mixers, double-cone mixers, vertical mixers, helical screw mixers and the like. The resins, fillers and additives are then compounded in a twin-screw extruder, a single-screw cokneader, planetary extruder or other suitable equipment. The premix is then processed through the extruder at a temperature in the range of 70-220 °C and preferably 70-120 °C. Liquid components, if used, are directly injected into the melt in the extruder. The extruded melt is cooled by passage through cooled nip-rollers on a cooling belt or compact cooler and chipped. If the formulation contains components having a high melting point or softening point the use of a high process temperature, for example above 150 °C, is advantageous. It is also preferred to process the formulation in two extruder passes with the catalysts added only in the second extruder pass and at the lowest practicable melt temperature, typically in the range of 90-120 °C. This reduces the risk of a runaway crosslinking reaction taking place in the extruder. The formulation in chip form is then either further processed to a powder for application by a EMB process, powder scattering or direct melt extrusion.

In one preferred embodiment of the invention, the formulation is extruded without catalyst and the catalyst added separately before the direct extrusion step, optionally in the form of a masterbatch in one of the resins, such as phenolic resin hardener.

A further embodiment of the invention is the direct melt extrusion of all the components of the formulation in one single pass. For this option an extruder with a long barrel (minimum length:bore diameter >36) is preferred. It is preferred to pass the slit-extrusion-coated substrate through a callandering roller directly after the slit extrusion. After slit extrusion the coated substrate can be passed through an oven to adjust the degree of b-staging before being cooled down and wound up.

If direct melt extrusion is used to apply the resin layer without reinforcement (2), it is possible to feed the coated substrate directly into the lamination equipment without winding up before. A particular advantage of the direct melt extrusion method of coating is that a much thicker layer can be laid down than by any other method. For example, the resin layer without reinforcement (3) can easily be made to a thickness of up to 500 µm, which is much thicker than is needed for embedding active components of typical size.

If a solvent-free coating process is used in which a solvent-free resin powder is applied to the substrate (powder scattering process), the extruded chips are first milled and optionally classified, preferably using a classifying mill and finally sieved to give a powder with a particle size having a size distribution peak maximum in the range 5-200 µm, preferably 10-100 µm and most preferably 30-80 µm. Other types of mill which can be used include pin mills, ultracentrifugal mills and the like. Classification of the powder is not strictly necessary, but is useful to reduce the amount of powder below 10 µm in size, which poses an inhalation hazard and to ensure that the amount of oversize particles is kept to a minimum. Milling and classification can be carried out as separate operations. Suitable sieves are gyratory sieves, vibratory sieves and ultrasonic sieves fitted with a suitable mesh in the range 60-300 µm, preferably 120-250 µm. The powder particle size distribution is determined by dry sieve analysis, sedimentation, Coulter counter or preferably by laser diffraction.

For solvent-free deposition using an electromagnetic brush process, the solvent-free resin powder is mixed with a suitable electromagnetic carrier, such as Type AT 100-01 from Büro-Communication Wagner GmbH in the ratio range 5:95 to 50:50, preferably 10:90 to 40:60 and most preferably 15:85 to 25:75 parts powder:carrier by weight and coated onto the carrier foil, which may be uncoated or already have been coated with resin layer (2) and laminated using a laboratory electromagnetic brush apparatus scattered on a scattering line using a rotating drum studded with needles. The spaces between the needles, the rotation speed of the electromagnetic drum and the speed at which the substrate passes underneath dose the meter the amount of powder applied to the substrate. A deposition method for solvent-free resin powders using an electromagnetic brush is disclosed for example in EP 1 807 219 A1 which is incorporated here by reference.

The coated carrier layer (1) is then passed through an oven and heat treated, preferably in a continuous reel-to-reel process. The coated resin of resin layer with reinforcement (2) is not fully cured but the oven settings must be chosen in such a manner that the resin still forms a closed film on the surface of the carrier layer (1) but at the same time remains in a semi-cured state, forming a so-called "b-staged" material. In the case where a powdered resin is used the high oven temperature causes the powder particles to melt, degass, coalesce and flow together to form a closed film on the copper surface. After cooling and winding up the roll, the coated carrier layer (1) is ready for the second step of the production.

The extent of the b-staging or degree of conversion is best determined by differential scanning calorimetry. By heating at a constant heating rate of 20 °C/min in an atmosphere of flowing nitrogen the extent to which the reactive groups present in the formulation have reacted during b-staging can be determined and compared to the enthalpy of the non-b-staged material. Excessive heating of the coating, i.e., b-staging, results in a resin layer (2) that is unable to flow sufficiently into the reinforcement on lamination. This results in voids under the reinforcement and poor embedding. Insufficient b-staging may result in a resin layer with excessive flow-out when material of the invention is pressed onto the electronic assembly. The extent of the b-staging required is therefore highly dependent on the initial viscosity of the formulation (before b-staging) and whether or not it contains a filler. In practice it has been found useful to use heating conditions sufficient to ensure a degree of conversion of 0.1-50 %, preferably 0.2-40 % and most preferably 0.3-25 % for formulations that are coated without solvents. For solvent coated formulations which may contain liquid resins, higher degrees of conversion are recommended: 1-80 %, preferably 2-60 % and most preferably 3-50 %. Ovens suitable for the b-staging process include infrared ovens, near infrared ovens, convection ovens and combinations thereof. Microwave ovens are also suitable provided that the carrier layer 1 is either non-metallic or non-conductive.

If a solvent coating operation is chosen, the temperature profile in the oven must be chosen which avoids the formation of bubble through the evaporation of solvent and which subsequently enables the resin to reach the required degree of b-staging.

The resin from the resin layer with reinforcement (2) is laminated, preferably in a reel-to-reel process, with a reinforcement, e.g., a glass fabric. This lamination operation is carried out at elevated temperature and with the application of pressure.

In one embodiment of the present invention, the coated substrate, optionally is laminated on-line, directly after b-staging and without a wind-up step. Suitable equipment for the embedding of the reinforcement are nip-roll laminators, heated calendaring rolls, heated drum-and-belt laminators, belt laminators, flat bed belt-laminators and combinations thereof. Heated presses with and without vacuum can also be used if a sheet-wise production is used instead of the preferred reel-to-reel process.

The preferred equipment for the embedding of the reinforcement is a flat-bed belt-laminator, most preferably the flat bed laminator is fitted with a subsequent calendaring roll.

For optimal embedding it is important that a combination of heat and temperature be used. The temperature range in which a flat bed laminator should be used with the material of the invention is 50-300 °C, preferably 70-200 °C and most preferably 100-170 °C. The pressure to be exerted on the belt is in the range of 0.05-100 N/cm², preferably 0.1-20 N/cm² and most preferably 0.3-10 N/cm². The callander roll pressure depends on the diameter of the rollers used, but should exert a pressure on the material of the invention greater than that used on the belt. The construction of the belt laminator should be such that a non-stick material such as polytetrafluoroethylene, a crosslinked silicone polymer or silicone paper is kept in contact with the composite build-up material during embedding operation. The carrier layer (1) thus coated with the resin layer with reinforcement (2) is then cooled to a temperature in the range of 0-100 °C, preferably 25-70 °C and most preferably 30-50 °C and wound up and the resulting roll is used in the next production step.

The carrier layer (1) with attached resin layer with reinforcement (2) is coated with a resin (resin layer without reinforcement (3)) for a second time using either a solvent process or solvent-free deposition process as previously described for the deposition of the resin of resin layer with reinforcement (2).

However, it was found to be of the utmost importance, that the resin of the resin layer without reinforcement (3) is deposited on top of the resin layer with reinforcement (2) by a solvent-free coating method, as solvents cannot be easily removed from the material of the invention once the solvent has diffused into resin layer with reinforcement (2). The consequence of using solvents to deposit resin layer (3) is the formation of solvent vapour bubbles under the reinforcement on heating. Alternatively, very mild heating conditions would have to be used to drive off the residual solvent, which would necessitate an excessively long drying zone and make the production process uneconomic.

The preferred solvent-free deposition method for deposition of the resin of resin layer without reinforcement (3) is selected from the group consisting of electromagnetic brush process, powder scattering process and direct melt extrusion process.

The most preferred deposition method for the resin of resin layer without reinforcement (3) is a deposition method for solvent-free resin powders selected from the group consisting of powder scattering process and direct melt extrusion process.

After winding up the roll is cut to sheets of the required sheet size according to the customers demand.

The described manufacturing process of a composite build-up material according to the present invention is continuous in the sense that all process steps are reel-to-reel processes. The thickness of each layer can be adjusted within a wide range, according to the targeted end application. Especially noteworthy is the fact that the resin formulations for each of the layers (2) and (3) can be tuned to its individual function. Also the type of glass fabric can easily be changed, the use of very thin glass fabrics does not pose any problem with handling since it is supplied from a roll and continuously laminated in the resin layer of the build up material. The problems known in the industry with the handling and the mechanical sensitivity of very thin prepregs are entirely avoided. The manufacturing of said build-up materials uses well known and established methods and readily available equipment in order to provide materials which are urgently needed. The ongoing trend towards higher reliability, increased miniaturization, and faster production cycles in the area of chip packaging demands these types of materials.

The following examples further illustrates the present invention.

### Example

### Preparation of the powder coating to be used as the resin for resin layer with reinforcement (2)

The resin components listed in Table 1 were weighed out in the quantities shown and thoroughly mixed together in a polyethylene bag.

**Table 1: components used for resin of resin layer with reinforcement (2)**

| Component | Quantity (g) |
|---|---|
| Multifunctional solid epoxy resin | 480 |
| Bakelit PF 0790 K03 | 180 |
| Submicron sized silica | 337 |
| Total: | 997 |

A dicyclopentadienyl-bridged multifunctional solid epoxy resin, Bakelit PF 0790 K03 which is a phenol-formaldehyde-based, phenolic resin (CAS-no. 9003-35-4), and a submicron sized silica filler with an average particle size of 0.3 microns and a spherical particle shape, are used as raw materials. The mixed components of the dielectric were then extruded on a 19 mm-bore, 5-zone, 24 I/d, twin screw extruder made by OMC, Italy and fitted with screws having the maximum number of mixing elements. The barrel temperature in the mixing zones was set to 100 °C and the rotation speed to 600 rpm, which gave a throughput of approximately 3 kg/hr and a melt temperature of 100 - 105 °C. The extruded melt was cooled by passage through water-cooled nip rollers and crushed. The finely crushed flakes were then mixed with Curezol 2MA-OK latent catalyst, in the proportion 997 g extruded flakes to 3 g Curezol 2MA-OK. The mixture containing the catalyst was then extruded a second time using the same conditions as for the first pass. The catalysed formulation was then crushed and milled using a Retsch ZM-1 Ultracentrifugal mill at 14'000 rpm and using a milling sieve, mesh size 0.25 mm. The resulting powder was subsequently sieved through a 160 micron sieve using a gyratory sieve made by Fuchs Maschinenbau AG, Granges Paccot, Switzerland.

The gel time of the resultant solvent-free resin powder was measured according to ASTM D3451 on a hot plate at 180°C and found to be 175 seconds.

### Deposition of the resin layer with reinforcement (2) onto the carrier layer (1)

A copper foil of 35 µm thickness as carrier layer (1) (Type JTC, Gould Electronics GmbH, Eichstetten, Germany) is coated in a reel-to-reel coating line with the resin powder prepared above using the electro magnetic brush coating technology. A quantity of 6 kg of said solvent-free resin powder is mixed intensively with 34 kg of magnetic carrier particles (DFC2023C, Dowa, Okayama City, Japan) for 30 minutes. This mixture is inserted to the container of the EMB machine (EMB Technology, Broek op Langedijk, The Netherlands) and kept in continuous movement using a fluidized bed. The magnetic drum speed is set to 90 m/min and the line speed to 6 m/min. The voltage is set to 500 V, and the gap between the brush drum and the copper foil is set to 4 mm. The amount of solvent-free resin powder which is transferred to the copper foil is continuously replenished using a powder feeding system (DDF pump, Ramseier Technolgies, Luterbach, Switzerland). The powder coating is molten in an IR oven, the surface temperature of the coating being 150 °C. The thickness of the resin coating is 30 µm as measured by the area weight. The thickness distribution over the width and the length of the sample is 30 µm ± 2 µm.

### Embedding of the reinforcement into resin layer with reinforcement (2)

The resin coated copper foil is inserted into a flat belt laminator and continuously passed in a reel to reel fashion through the laminator together with a glass fabric type 1015 (Company Unitika) with a line speed of 3 m/min. The lamination temperature is 140 °C. This intermediate shows no blisters, the glass fabric is well embedded at all positions in the length and the width of the substrate and shows no wrinkles.

### Coating of resin layer without reinforcement (3)

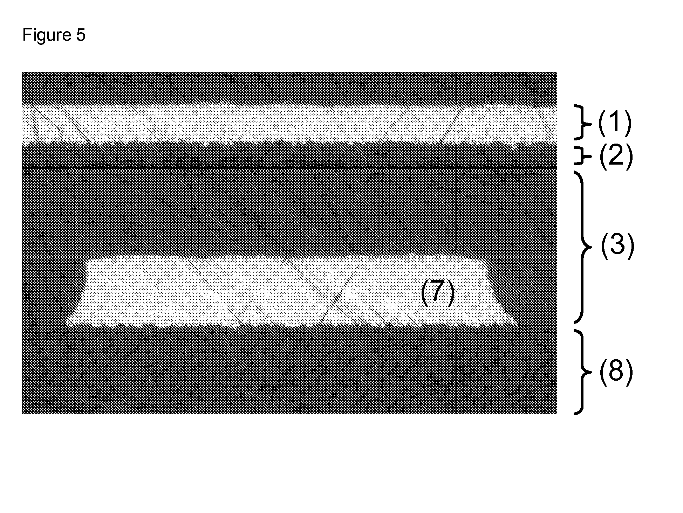

The copper foil (= carrier layer (1)) with coated resin layer with reinforcement (2) is again coated on the EMB machine as described in above. This time the bias voltage is increased to 1500 V and the line speed reduced to 4 m/min in order to reach a higher coating thickness. The finished composite build-up consisting of a carrier layer (1), a resin layer with reinforcement (2) and a resin layer without reinforcement (3) is pressed on a structured laminate (7) with copper tracks serving as a active component dummy (6) of the size of typical silicon dies and a height of 70 µm (maximum temperature = 190 °C, maximum pressure = 20 bar). A cross section micrograph shows that the resin layer without reinforcement (3) evenly covers the active component dummy (6) and the glass fabric in the resin layer with reinforcement (3) ensures a good planarity of the surface (Fig. 5). The active component dummy (6) is well covered by the resin layer without reinforcement (3). The planarity of the carrier layer (1) above the embedded active component dummy (6) is archived.

## Claims

1. A composite build-up material suitable for embedding active components, the composite build-up material having a layer sequence in the following order
(i) a carrier layer (1) having a thickness of 1 to 400 µm,
(ii) a resin layer with reinforcement (2) having a thickness of 1 to 200 µm and
(iii) a resin layer without reinforcement (3) having a thickness of 1 to 500 µm.

2. The composite build-up material according to claim 1 wherein the material used for carrier layer (1) is selected from the group consisting of copper, aluminium, tin, paper, polymer foils made of polymers selected from the group consisting of polyethylene therephthalate (PET), polyethylene naphthalate (PEN), polyimide, polyether ether ketone (PEEK), cyclic olefin copolymer (COC), polyamide, polytetrafluoroethylene (PTFE), fluorinated ethylene propylene (FEP), ethylene tetrafluoroethylene (ETFE), THV (co-polymer of tetrafluoroethylene, hexafluoropropylene and vinylidene fluoride), polychlorotrifluoroethylene (PCTFE), polyvinylfluoride (PVF), polyvinylidene fluoride (PVDF), perfluoro alkoxy (PFA), MFA (co-polymer of tetrafluoroethylene and per-fluoro vinylether), polyarylate, ECTF ethylene-chlorotrifluoroethylene (ECTFE), polyethersulfone (PES), polymethylpentene (PMP), polyetherimide, polysulfone, and crosslinked polymer foils.

3. The composite build-up material according to any of the foregoing claims wherein the material for the carrier layer (1) is selected from the group consisting of copper, aluminium polyethylene naphthalate (PEN), cyclic olefin copolymer (COC) and polyarylate.

4. The composite build-up material according to any of the foregoing claims wherein the resin used for the resin layer with reinforcement (2) is selected from the group consisting of epoxy resins, cyanate ester resins, bismaleimide resins, bismaleide triazine resins, benzoxazine resins, and mixtures thereof.

5. The composite build-up material according to any of the foregoing claims wherein the material for reinforcement in the resin layer with reinforcement (2) is selected from woven and non-woven fabrics of materials selected from the group consisting of silica glass, silica glass containing metal oxides of group 1 metals, silica glass containing metal oxides of group 2 metals, silica glass containing metal oxides of group 1 and group 2 metals, E-glass, alumino silicates, silicon nitride, boron nitride, Wollastonite, ceramic oxides, aramide, and mixtures thereof.

6. The composite build-up material according to any of the foregoing claims wherein the resin of the resin layer without reinforcement (3) is selected from the group consisting of epoxy resins, cyanate esters, bismaleimides, bismaleimide triazine resin, benzoxazines, and blends thereof.

7. The composite build-up material according to any of the foregoing claims wherein the resin of the resin layer with reinforcement (2) is an epoxy resin and the hardener is selected from the group consisting of dicyandiamide, phenol-formaldehyde novolac resins, cresol-formaldehyde novolac resins, triazine-substituted phenol-formaldehyde novolav resins, tris-phenol novolacs, cyanate esters, orthotoluyl-bisguanide, and mixtures thereof.

8. The composite build-up material according to any of the foregoing claims wherein the resin in the resin layer without reinforcement (3) is an epoxy resin and the hardener is independently selected from the group consisting of dicyandiamide, phenol-formaldehyde novolac resins, cresol-formaldehyde novolac resins, triazine-substituted phenol-formaldehyde novolav resins, tris-phenol novolacs, cyanate esters, orthotoluyl-bisguanide, and mixtures thereof.

9. The composite build-up material according to any of the foregoing claims wherein the composite build-up material has a layer sequence in the following order of
(i) a carrier layer (1) having a thickness of 1 to 400 µm,
(ii) b) a release layer (4),
(ii) a resin layer with reinforcement (2) having a thickness of 1 to 200 µm and
(iii) a resin layer without reinforcement (3) having a thickness of 1 to 500 µm.

10. The composite build-up material according to claims 1 to 8 wherein the composite build-up material has a layer sequence in the following order of
(i) a carrier layer (1) having a thickness of 1 to 400 µm,
(ii) b) a primer layer (5),
(ii) a resin layer with reinforcement (2) having a thickness of 1 to 200 µm and
(iii) a resin layer without reinforcement (3) having a thickness of 1 to 500 µm.

11. The composite build-up material according to any of the foregoing claims wherein an active component (6) is embedded into the resin layer without reinforcement (3).

12. Method of preparing a substrate according to any of the foregoing claims wherein the resin of the resin layer without reinforcement (3) is deposited on the preceding layer from a solvent-free resin powder.

13. Method of preparing a substrate according to claim 13 wherein the solvent-free resin powder is deposited onto the preceding layer by a method selected from the group consisting of electromagnetic drum process, powder scattering process and direct melt extrusion process.
